# EUROPÄISCHE PATENTSCHRIFT

(11) **EP 0 927 461 B1**
(45) Veröffentlichungstag und Bekanntmachung des Hinweises auf die Patenterteilung: **17.10.2001**
(21) Anmeldenummer: 97935485.9
(22) Anmeldetag: 25.07.1997
(51) Int. Cl.: H03K 17/082

(54) **TEMPERATURGESCHÜTZTES ELEKTRISCHES SCHALTER-BAUELEMENT**
TEMPERATURE PROTECTED ELECTRIC SWITCHING COMPONENT
ELEMENT COMMUTATEUR ELECTRIQUE A PROTECTION THERMIQUE

(30) Priorität: 18.09.1996 DE 19638089
(43) Veröffentlichungstag der Anmeldung: 07.07.1999
(73) Patentinhaber: Infineon Technologies AG, 81669 München (DE)
(72) Erfinder: TIHANYI, Jenö, D-85551 Kirchheim (DE)
(74) Vertreter: Zedlitz, Peter, Dipl.-Inf.
(86) Internationale Anmeldenummer: DE9701575
(87) Internationale Veröffentlichungsnummer: WO9812815

(56) Entgegenhaltungen:
- EP-A- 0 617 497
- US-A- 4 345 218
- US-A- 5 267 118
- HEIL H ET AL: "MINI-PROFETS IN MILLI-SMART TECHNOLOGY: HIGH-SIDE SMART POWER SWITCHES WITH ALL-ROUND PROTECTION" SIEMENS COMPONENTS, Bd. 31, Nr. 4, Juli 1996, Seiten 20-22, XP000636648
- REINMUTH K ET AL: "HITHETS WITH CURRENT SENSING: LOW-SIDE SWITCHES UNLIMITED" SIEMENS COMPONENTS, Bd. 31, Nr. 3, Mai 1996, Seiten 18-20, XP000623757
- RABL H: "SMART SIPMOS COMPONENTS" SIEMENS COMPONENTS, Bd. 25, Nr. 6, 1.Dezember 1990, Seiten 233-239, XP000177066

## Beschreibung

Die Erfindung betrifft ein temperaturgeschütztes elektrisches Schalter-Bauelement nach dem Oberbegriff des Patentanspruchs 1. Ein solches temperaturgeschütztes elektrisches Schalter-Bauelement ist beispielsweise ein temperaturgeschützter Feldeffekttransistor (PROFET, HITFET, TEMPFET).

Temperaturgeschützte Feldeffekttransistoren, die zumeist als Halbleiterschalter eingesetzt werden, sollen im Kurzschlußfall einen Laststrom abschalten, sobald die Temperatur bei dem Feld effekttransistor eine bestimmte obere Grenze erreicht. So können in bestimmten Gehäusen Leiterplatten nur Temperaturen bis etwa 150° C aushalten, weil bei höheren Temperaturen die Lötpunkte dieser Leiterplatten zerstört werden. Mit anderen Worten, bei Überschreiten der Temperatur von 150° C sollen ein Temperatursensor und eine diesem zugeordnete Logik einen Kurzschlußfall feststellen und den Laststrom mittels des als Halbleiterschalter betriebenen Feldeffekttransistors abschalten.

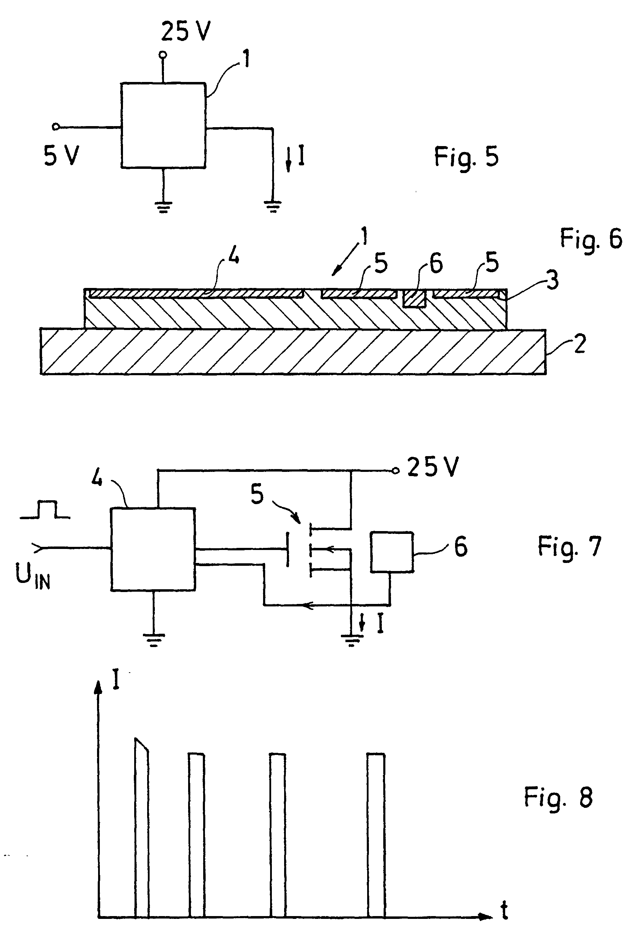

Ein derartiger bestehender temperaturgeschützter Feldeffekttransistor 1 ist schematisch in Fig. 5 gezeigt (siehe, z.B., Heil H. et al: "Mini-PROFETS in milli-smart technology : High-side Smart Power Switches with all-round protection", Siemens Components, Bd. 31, Nr.4, Juli 1996, Seiten 20-22). An diesem temperaturgeschützten Feldeffekttransistor 1 liegen beispielsweise eine Betriebsspannung von 25 V und eine Eingangsspannung von 5 V. Überschreitet die Temperatur einen Wert von ca. 150° C, so wird ein Laststrom I abgeschaltet.

Fig. 6 zeigt den temperaturgeschützten Feldeffekttransistor von Fig. 5 in einer schematischen Schnittdarstellung. Auf einer Metallplatte 2 befindet sich ein Halbleiterkörper bzw. - chip 3 mit einem integrierten Schaltungsteil (IC-Teil) 4 und einem Feldeffekttransistor 5, von dem schematisch Source und Drain dargestellt sind. Im Bereich des Zellenfeldes des Feldeffekttransistors 5 ist ein Temperatursensor 6 angeordnet, bei dem es sich um eine Diode oder einen Bipolartransistor handeln kann.

In Fig. 7 ist die elektrische Schaltungsanordnung des temperaturgeschützten Feldeffekttransistors 1 gezeigt. Der Temperatursensor 6 liegt im Bereich des Feldeffekttransistors 5, durch den der Laststrom I fließt. Der IC-Teil 4 bildet eine Logik, mit der ein oberer und ein unterer Schwellenwert für die Temperatur einstellbar sind. Überschreitet die vom Temperatursensor 6 gemessene Temperatur den oberen Schwellenwert, so schaltet die Logik den Feldeffekttransistor 5 ab, so daß der Laststrom I zu fließen aufhört. Dadurch setzt ein Abkühlen an der Stelle des Temperatursensors 6 ein. Erreicht dann die vom Temperatursensor 6 gemessene Temperatur den unteren Schwellenwert, so schaltet die Logik den Feldeffekttransistor 5 wieder ein, so daß der Laststrom I wieder zu fließen beginnt. Nach erneutem Erreichen des oberen Schwellenwertes durch die vom Temperatursensor 6 gemessene Temperatur erfolgt ein abermaliges Abschalten des Feldeffekttransistors 5, bis wiederum die untere Schwellenwert-Temperatur erreicht ist.

Es entsteht so ein periodischer Ein-/Abschaltvorgang, wie dieser in Fig. 8 gezeigt ist, wobei sich die Temperatur des Halbleiterkörpers 3 auf einen Wert zwischen den beiden Schwellenwerten einpendelt. Die Periodenzeit hängt dabei von der Kühlung insbesondere über die Metallplatte 2 ab.

Temperaturgeschützte Halbleiterschalter werden insbesondere zusammen mit Lampen und Motoren als Lasten verwendet. Es hat sich nun gezeigt, daß diese Lasten nach einem Kurzschluß nicht wieder einschalten, weil der beim Wiedereinschalten auftretende Stoßstrom erneut als Kurzschluß empfunden wird.

Es ist daher **Aufgabe** der vorliegenden Erfindung, ein temperaturgeschütztes elektrisches Schalter-Bauelement zu schaffen, das eine niedrige Temperatur der Lötpunkte und ein sicheres Wiedereinschalten einer Last nach einem Kurzschluß gewährleistet.

Diese Aufgabe wird bei einem temperaturgeschützten elektrischen Schalter-Bauelement nach dem Oberbegriff des Patentanspruches 1 erfindungsgemäß durch die in dessen kennzeichnendem Teil enthaltenen Merkmale gelöst.

Vorteilhafte Weiterbildungen der Erfindung ergeben sich aus den Unteransprüchen.

Obwohl die Erfindung allgemein auf elektrische Schalter-Bauelemente anwendbar ist, bei denen eine Temperaturerhöhung über eine kritische Grenze vermieden werden soll, liegt ein bevorzugtes Anwendungsgebiet der Erfindung bei Halbleiterschaltern in der Form von temperaturgeschützten Feldeffekttransistoren.

Wesentlich an der Erfindung ist, daß zusätzlich zu dem Temperatursensor, der vorzugsweise an der "heißesten" Stelle des temperaturgeschützten elektrischen Schalter-Bauelements vorgesehen ist, noch ein weiterer Temperatursensor zum Einsatz gelangt, dessen Schwellenwerte unterhalb von denjenigen des Temperatursensors liegen, der an einer sich nur relativ wenig erwärmenden Stelle des temperaturgeschützten elektrischen Schalter-Bauelementes gelegen ist und der die Oszillation des Laststromes ein- und ausschaltet.

Der eine oder erste Temperatursensor wird bevorzugt im Zellenfeld des Schalter-Bauelements angeordnet, da dort gewöhnlich die sich am raschesten erwärmende Stelle ist. Dieser Temperatursensor hat eine relativ kleine Hysterese und - wie bereits erläutert - höhere Schwellenwerte als der weitere Temperatursensor. Im Falle eines Kurzschlusses wird der erste Temperatursensor periodisch ein- und ausgeschaltet, wobei die Temperatur des Halbleiterkörpers ansteigt, wenn das Schalter-Bauelement ein Halbleiterschalter ist. Der weitere zweite Temperatursensor ist vom Schalter-Bauelement weiter entfernt und wird so nur relativ langsam heiß. Seine Schwellenwerte sind niedriger als die des ersten Temperatursensors, und seine Hysterese ist größer als die des ersten Temperatursensors.

Wenn die Temperatur beim zweiten Temperatursensor dessen oberen oder dritten Schwellenwert erreicht, wird die Oszillation des Laststromes mit dem ersten Temperatursensor abgeschaltet. Dadurch verteilt sich die Temperatur gleichmäßig in dem gesamten Schalter-Bauelement, so daß dieses allmählich abkühlt. Sobald die Temperatur beim zweiten Temperatursensor dessen unteren oder vierten Schwellenwert erreicht, wird die Oszillation des Laststromes mit dem ersten Temperatursensor wieder eingeschalten.

Es liegen so also zwei Stromoszillationen vor: Eine schnelle Oszillation aufgrund des ersten Temperatursensors, welche die Temperatur im Schalter-Bauelement stabilisiert, und eine langsame Oszillation aufgrund des zweiten Temperatursensors, welche die schnelle Oszillation periodisch unterbindet. Als Ergebnis wird damit die Lötpunkt- bzw. Gehäusetemperatur etwa in der Mitte der Hysterese des zweiten Temperatursensors eingestellt. Nach einem Kurzschluß kann eine Last, beispielsweise eine Lampe oder ein Motor, zuverlässig wieder eingeschaltet werden, da die Temperatur des Schalter-Bauelements wesentlich höher sein kann als die Lötpunkt- bzw. Gehäusetemperatur beim Kurzschluß ist.

Der zweite Temperatursensor kann auf einem weiteren Bauelement bzw. einem weiteren Halbleiterkörper oder IC-Chip untergebracht sein, was auch für Chip-auf-Chip-Bauelemente gilt.

Die Temperatursensoren können gleich, beispielsweise als Diode oder Bipolartransistor, oder auch unterschiedlich aufgebaut sein.

Nachfolgend wird die Erfindung anhand der Zeichnungen näher erläutert. Es zeigen:
- Fig. 1: eine Schnittdarstellung des erfindungsgemäßen Halbleiterschalters;
- Fig. 2: ein Blockschaltbild für den Halbleiterschalter von Fig. 1;
- Fig. 3: Schwellenwerte der beiden Temperatursensoren;
- Fig. 4: die Oszillation des Laststromes beim erfindungsgemäßen Schalter-Bauelement;
- Fig. 5: eine Prinzipdarstellung eines bestehenden PROFETs;
- Fig. 6: eine Schnittdarstellung durch den PROFET von Fig. 5;
- Fig. 7: ein Blockschaltbild des PROFETs von Fig. 5 und
- Fig. 6: die Oszillation des Laststroms des PROFETs von Fig. 5.

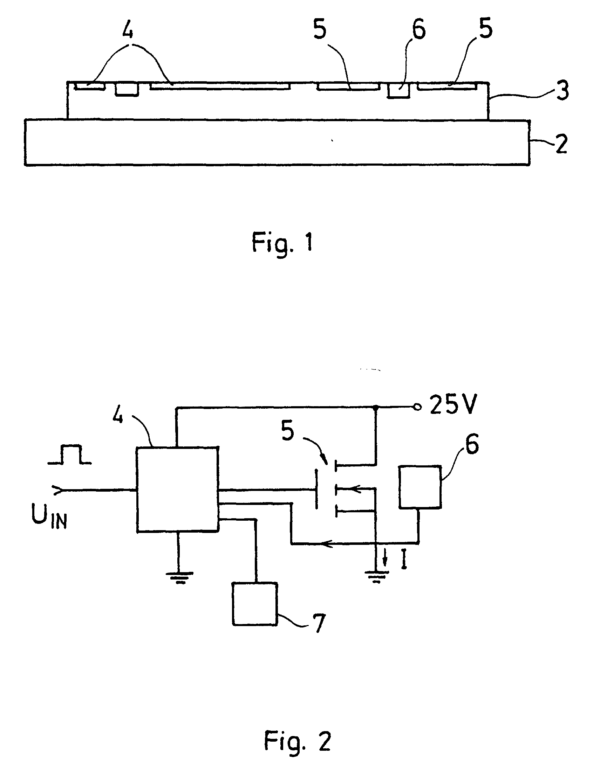

Die Fig. 5 bis 8 sind bereits eingangs erläutert worden. In den Fig. 1 bis 4, die die Erfindung zeigen, werden einander entsprechende Teile mit den gleichen Bezugszeichen wie in den Fig. 5 bis 8 versehen.

Wie in Fig. 1 gezeigt ist, ist im IC-Teil 4 ein zweiter Temperatursensor 7 zusätzlich zum ersten Temperatursensor 6 vorgesehen. Beide Temperatursensoren 6, 7 können gleich oder auch verschieden aufgebaut sein und beispielsweise aus einer Diode oder einem Bipolartransistor bestehen. Während der erste Temperatursensor 6 an einer sich rasch erwärmenden Stelle, nämlich in der Nähe des Feldeffekttransistors 5 gelegen ist, befindet sich der zweite Temperatursensor 7 weit weg vom Feldeffekttransistor 5 und wird so wesentlich langsamer "heiß" als der erste Temperatursensor 6.

Wie im Blockschaltbild von Fig. 2 gezeigt ist, ist der zweite Temperatursensor 7 ähnlich wie der erste Temperatursensor 6 mit der Logik bzw. dem IC-Teil 4 verbunden.

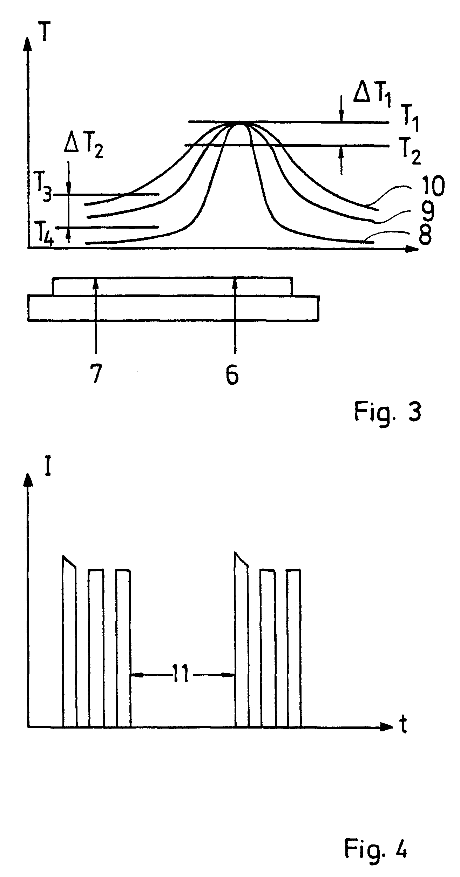

Fig. 3 zeigt die Einstellung der Schwellenwerte der beiden Temperatursensoren 6 und 7. Der obere Schwellenwert T₁ und der untere Schwellenwert T₂ des ersten Temperatursensors 6 liegen über dem oberen Schwellenwert T₃ und dem unteren Schwellenwert des zweiten Temperatursensors 7. Die Hysterese ΔT₁ des ersten Temperatursensors 6 ist dabei etwas kleiner als die Hysterese ΔT₂ des zweiten Temperatursensors 7.

Kurven 8, 9 und 10 in Fig. 3 zeigen, wie sich die Temperatur allmählich im Schalter-Bauelement ausbreitet. Zunächst liegt eine Temperaturverteilung entsprechend der Kurve 8 vor. Es tritt hier eine Oszillation des Laststromes I entsprechend dem Ein- und Ausschalten durch den ersten Temperatursensor 6 auf. Mit steigender Temperatur im Schalter-Bauelement (vergleiche Kurve 9) wird schließlich am Ort des zweiten Temperatursensors 7 dessen oberer Schwellenwert T₃ erreicht. Zu diesem Zeitpunkt schaltet dann die Logik bzw. der IC-Teil 4 die Oszillation durch den ersten Temperatursensor 6 ab, so daß ein oszillationsfreier Bereich 11 entsteht (vergleiche Fig. 4).

Die Temperatur verteilt sich sodann gleichmäßig im Schalter-Bauelement, wobei dieses abkühlt. Wird am Ort des zweiten Temperatursensors 7 der untere Schwellenwert T₄ erreicht, so wird die Oszillation durch den ersten Temperatursensor 6 wieder eingeschaltet.

Infolge der "schnellen" Oszillation mit dem ersten Temperatursensor 6 und der "langsamen" Oszillation mit dem zweiten Temperatursensor 7 stellt sich die Temperatur der Lötpunkte bzw. die Gehäusetemperatur etwa auf die Mitte der Hysterese des zweiten Temperatursensors 7 ein.

Damit kann eine Last, wie z.B. eine Lampe oder ein Motor, nach einem Kurzschluß zuverlässig wieder eingeschaltet werden, da die Temperatur des Feldeffekttransistors 5 bzw. Schalters wesentlich höher sein kann als die Gehäusetemperatur beim Kurzschluß.

## Patentansprüche

1. Temperaturgeschütztes elektrisches Schalter-Bauelement (5), insbesondere Halbleiterschalter, bei dem ein erster Temperatursensor (6) an einer ersten Stelle vorgesehen ist, der das Schalter-Bauelement einen Laststrom (I) bei Überschreiten eines ersten Schwellenwertes (T₁) durch die durch ihn erfaßte Temperatur abschalten und den Laststrom (I) bei Unterschreiten eines zweiten Schwellenwertes (T₂), der niedriger als der erste Schwellenwert (T₁) ist, durch die durch ihn erfaßte Temperatur wieder einschalten läßt, so daß der Laststrom eine Oszillation ausführt,
**dadurch gekennzeichnet,**
**daß** ein zweiter Temperatursensor (7), der an einer zweiten Stelle vorgesehen ist, die von der ersten Stelle verschieden ist und im Betrieb des Schalter-Bauelements eine niedrigere Temperatur annimmt als die erste Stelle, einen dritten Schwellenwert (T₃), der niedriger ist als der zweite Schwellenwert (T₂), und einen vierten Schwellenwert (T₄), der niedriger ist als der dritte Schwellenwert (T₃), aufweist, und
**daß** der zweite Temperatursensor (7) das Schalter-Bauelement die Oszillation des Laststromes (I) bei Überschreiten des dritten Schwellenwertes (T₃) durch die durch ihn erfaßte Temperatur abschalten und bei Unterschreiten des vierten Schwellenwertes (T₄) durch die durch ihn erfaßte Temperatur wieder einschalten läßt.

2. Temperaturgeschütztes elektrisches Schalter-Bauelement nach Anspruch 1,
**dadurch gekennzeichnet,**
**daß** die erste Stelle die im Betrieb wärmste Stelle des Bauelementes ist.

3. Temperaturgeschütztes elektrisches Schalter-Bauelement nach
Anspruch 1 oder 2,
**dadurch gekennzeichnet,**
**daß** die zweite Stelle sich im Betrieb im Vergleich zur ersten Stelle nur langsam erwärmt.

4. Temperaturgeschütztes elektrisches Schalter-Bauelement nach
einem der Ansprüche 1 bis 3,
**dadurch gekennzeichnet,**
**daß** der Abstand (ΔT₁) zwischen dem ersten und dem zweiten Schwellenwert kleiner ist als der Abstand (ΔT₂) zwischen dem dritten und vierten Schwellenwert.

5. Temperaturgeschütztes elektrisches Schalter-Bauelement nach
einem der Ansprüche 1 bis 4,
**dadurch gekennzeichnet,**
**daß** die zweite Stelle auf dem Bauelement vorgesehen ist.

6. Temperaturgeschütztes elektrisches Schalter-Bauelement nach einem der Ansprüche 1 bis 4,
**dadurch gekennzeichnet,**
**daß** die zweite Stelle auf einem weiteren Bauelement vorgesehen ist.

7. Temperaturgeschütztes elektrisches Schalter-Bauelement nach einem der Ansprüche 1 bis 6,
**dadurch gekennzeichnet,**
**daß** der erste und/oder der zweite Sensor als Diode und/oder als Bipolartransistor ausgeführt sind.

8. Temperaturgeschütztes elektrisches Schalter-Bauelement nach einem der Ansprüche 1 bis 7,
**dadurch gekennzeichnet,**
**daß** es einen Schalter-MOSFET (5) aufweist.

## Claims

1. Temperature-protected electrical switch component (5), in particular semiconductor switch, in which a first temperature sensor (6) is provided at a first location, which temperature sensor causes the switch component to switch a load current (I) off when the temperature detected by said temperature sensor exceeds a first threshold value (T₁), and to switch the load current (I) on again when the temperature detected by said temperature sensor falls below a second threshold value (T₂), which is lower than the first threshold value (T₁), with the result that the load current forms an oscillation,
**characterized**
**in that** a second temperature sensor (7), which is provided at a second location that is different from the first location and, during operation of the switch component, assumes a lower temperature than the first location, has a third threshold value (T₃), which is lower than the second threshold value (T₂), and a fourth threshold value (T₄), which is lower than the third threshold value (T₃), and
**in that** the second temperature sensor (7) causes the switch component to switch off the oscillation of the load current (I) when the temperature detected by said temperature sensor exceeds the third threshold value (T₃), and to switch it on again when the temperature detected by said temperature sensor falls below the fourth threshold value (T₄).

2. Temperature-protected electrical switch component according to Claim 1,
**characterized**
**in that** the first location is that location of the component which is warmest during operation.

3. Temperature-protected electrical switch component according to Claim 1 or 2,
**characterized**
**in that** the second location is heated only slowly in comparison with the first location during operation.

4. Temperature-protected electrical switch component according to one of Claims 1 to 3,
**characterized**
**in that** the interval (ΔT₁) between the first and the second threshold value is smaller than the interval (ΔT₂) between the third and fourth threshold values.

5. Temperature-protected electrical switch component according to one of Claims 1 to 4,
**characterized**
**in that** the second location is provided on the component.

6. Temperature-protected electrical switch component according to one of Claims 1 to 4,
**characterized**
**in that** the second location is provided on a further component.

7. Temperature-protected electrical switch component according to one of Claims 1 to 6,
**characterized**
**in that** the first and/or the second sensor are designed as a diode and/or as a bipolar transistor.

8. Temperature-protected electrical switch component according to one of Claims 1 to 7,
**characterized**
**in that** it has a switch MOSFET (5).

## Revendications

1. Composant (5) électrique formant interrupteur qui est protégé de l'effet de la température, notamment interrupteur à semiconducteur, dans lequel il est prévu un premier capteur (6) de température en un premier point où le composant formant interrupteur interrompt le passage d'un courant (I) de charge lors du dépassement d'une première valeur (T₁) de seuil par la température qu'il repère, et laisse passer à nouveau le courant (I) de charge lorsque l'on passe en dessous d'une deuxième valeur (T₂) de seuil inférieure à la première valeur (T₁) de seuil de la température qu'il repère, de sorte que le courant de charge effectue une oscillation,
**caractérisé**
**en ce qu'**un second capteur (7) de température, qui est prévu en un second point qui est différent du premier point et qui prend, en fonctionnement du composant formant interrupteur, une température plus basse que le premier point, a une troisième valeur (T₃) de seuil qui est plus basse que la deuxième valeur (T₂) de seuil et a une quatrième valeur (T₄) de seuil qui est plus basse que la troisième valeur (T₃) de seuil et en ce que le second capteur (7) de température interrompt, dans le composant formant interrupteur, l'oscillation du courant (I) de charge, lorsque la troisième valeur (T₃) de seuil est dépassée par la température qu'il relève et rétablit l'oscillation, lorsque l'on passe en dessous de la quatrième valeur (T₄) de seuil pour la température qu'il relève.

2. Composant électrique formant interrupteur qui est protégé de l'effet de la température suivant la revendication 1, **caractérisé en ce que** le premier point est le point du composant qui est le plus chaud en fonctionnement.

3. Composant électrique formant interrupteur qui est protégé de l'effet de la température suivant la revendication 1 ou 2, **caractérisé en ce que** le second point ne se réchauffe que plus lentement en fonctionnement que le premier point.

4. Composant électrique formant interrupteur qui est protégé de l'effet de la température suivant l'une des revendications 1 à 3, **caractérisé en ce que** l'intervalle ΔT₁ entre la première et la deuxième valeur de seuil est inférieur à l'intervalle ΔT₂ entre la troisième et la quatrième valeur de seuil.

5. Composant électrique formant interrupteur qui est protégé de l'effet de la température suivant l'une des revendications 1 à 4, **caractérisé en ce que** le second point est prévu sur le composant.

6. Composant électrique formant interrupteur qui est protégé de l'effet de la température suivant l'une des revendications 1 à 4, **caractérisé en ce que** le second point est prévu sur un autre composant.

7. Composant électrique formant interrupteur qui est protégé de l'effet de la température suivant l'une des revendications 1 à 6, **caractérisé en ce que** le premier et/ou le second capteur sont constitués sous la forme d'une diode ou d'un transistor bipolaire.

8. Composant électrique formant interrupteur qui est protégé de l'effet de la température suivant l'une des revendications 1 à 7, **caractérisé en ce qu'**il comprend un MOSFET (5) formant interrupteur.
